Europäisches Patentamt

European Patent Office

Office européen des brevets

(11) Publication number: **0 441 392 A2**

## EUROPEAN PATENT APPLICATION

(21) Application number: 91101762.2

(22) Date of filing: 08.02.91

(51) Int. Cl.⁵: **H01L 23/485**, H01L 23/29

(30) Priority: 08.02.90 JP 27092/90

(43) Date of publication of application:
14.08.91 Bulletin 91/33

(84) Designated Contracting States:
DE FR GB

(71) Applicant: Kabushiki Kaisha Toshiba
72, Horikawa-cho Saiwai-ku
Kawasaki-shi(JP)

(72) Inventor: Miyamoto, Koji, c/o Intellectual
Property Division
Kabushiki Kaisha Toshiba, 1-1 Shibaura
1-chome
Minato-ku, Tokyo 105(JP)

(74) Representative: Lehn, Werner, Dipl.-Ing. et al
Hoffmann, Eitle & Partner Patentanwälte
Arabellastrasse 4
W-8000 München 81(DE)

(54) MOS type semiconductor integrated circuit.

(57) On the surface area of the N type semiconductor substrate (11) the P$^+$ type source and drain regions (15) are provided. On the substrate surface between the above-mentioned source and drain regions (15), the gate electrode (13) is provided. On the side wall of the above-mentioned gate electrode (13), the CVD oxide film (14) is provided. The source and drain electrodes (19) are formed via contact holes (18) to make contact with the respective surfaces of the above-mentioned source and drain regions (15). The silicone nitride film (16) is formed on the substrate surface except the above-mentioned contact holes (18).

F I G. 6

## MOS TYPE SEMICONDUCTOR INTEGRATED CIRCUIT

The present invention relates to the MOS type semiconductor integrated circuit, and more specifically to the construction of the layer insulation film which is less subject to moving ions or hot electrons.

The PSG (phosphorus silicate glass) film or the laminated film consisting of PSG film and silicone nitride film have been well known as a final passivation film for the MOS type semiconductor integrated circuit. From the viewpoint of moisture resistance and reliability, at present the latter laminated film consisting of the PSG film and silicone nitride film are popularly used. However, in the EPROM and other ultra-violet ray erasable semiconductor integrated circuits, this laminated film cannot be used for the final passivation film, because the generally known silicone nitride film scarcely passes the ultra-violet ray. Consequently, in the above-mentioned semiconductor integrated circuits, only the PSG film can be used for the final passivation film.

However, recently with the refinement of transistors, variations in transistor characteristics due to the effect of impurities such as moving ions and hot electrons have constituted a large problem.

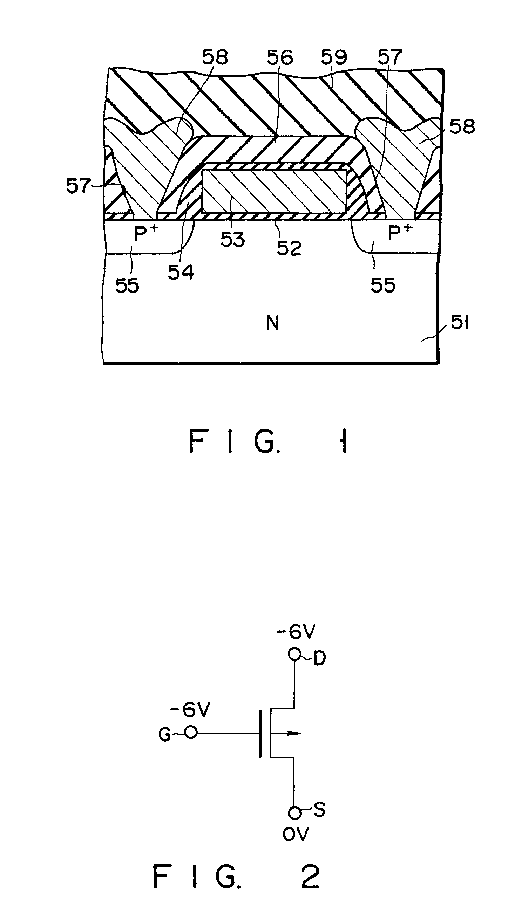

Fig. 1 shows the element construction of the conventional MOSFET. This MOSFET is of a P channel type. Conventionally, this MOSFET is composed by the following process.

At first, a gate oxide film 52 is formed on the surface of the N type semiconductor substrate 51. Then, the polysilicone gate 53 is formed by the well-known PEP (photo etching process). Then, only on the side wall of the polysilicone gate 53, the CVD oxide film 54, for example, is selectively formed. Thereafter, on the outer side of the above-mentioned CVD oxide film 54, $P^+$ type diffusion regions 55, 55, which serve as source and drain regions, are formed by the ion injection process, for example. Furthermore, as a layer insulation film, the CVD oxide film 56 containing phosphorus (P) or boron (B) is formed on the entire surface. Then, after the contact holes 57, 57, which are connected to the surfaces of the above-mentioned $P^+$ type diffusion regions 55, 55, are opened, the metallic film for wiring is evaporated on the overall surface, which is patterned to form the source and drain electrodes 58, 58. Now, the PSG film 59 is formed on the entire surface as the final passivation film.

However, the FET formed in this manner is likely to be subject to the effect of moving ions and other impurities as FET is refined.

In general, to determine the transistor reliability, the high-temperature high-humidity stress test is well known. Taking an example for the P-channel MOS FET, this test is conducted to measure the time-dependent characteristics of threshold voltage $V_{TH}$ under the high-temperature high-humidity surroundings with the standard voltage of 0 V applied to the source S and the voltage greater than the normal operation, such as -6 V, applied to the drain D and gate G as shown in Fig. 2.

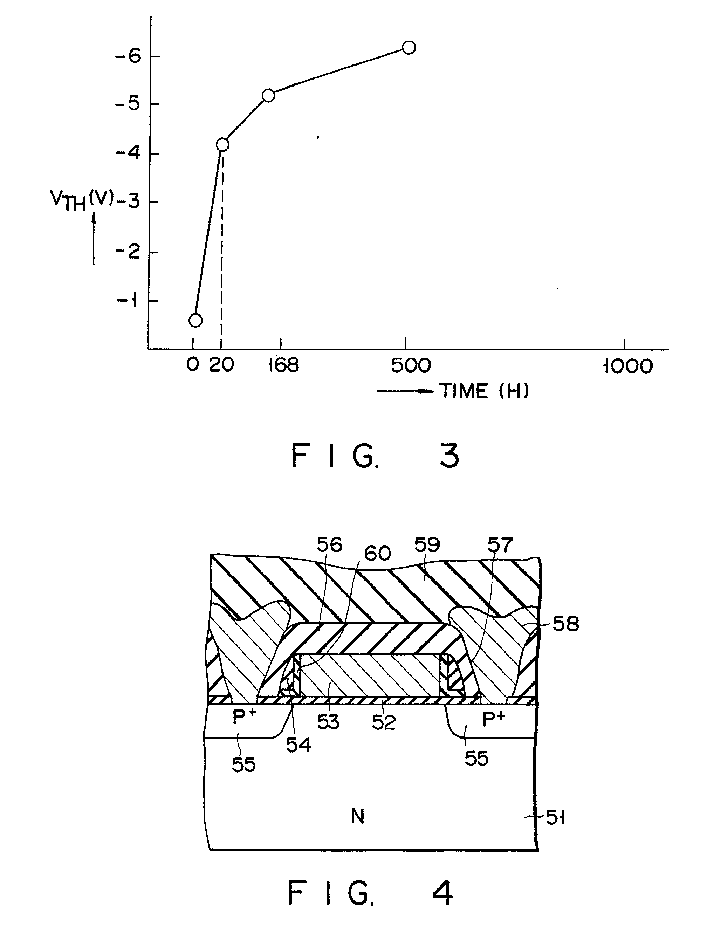

Fig. 3 shows the results of the stress test conducted on the FET of the above-mentioned construction. For the test conditions, the temperature is 85°C, humidity 85%, and applied voltage -6 V. According to these characteristics, the threshold voltage greatly varies during the period from the beginning of the test to 20 hours after the start of the test. This kind of threshold voltage variations is caused by the poor moisture resistance of the PSG film, which is the final passivation film. That is, the PSG film is easy to pass the moisture content, and moving ion, such as $Na^+$, which is present on the PSG film surface or in the atmosphere, enters with the entry of moisture content. During the stress test, since negative voltage is applied to the FET drain and gate, $Na^+$ entering the inside is attracted to the drain and gate and collects at the interface between gate oxide films, causing the threshold voltage to vary.

For the poor moisture resistance as described above, conventionally, the FET construction as disclosed in "1982 IEEE PROCEEDING, SECONDARY, SLOW TRAPPING - A NEW MOISTURE INDUCED INSTABILITY PHENOMENON IN SCALED CMOS DEVICES, M NOYORI et al." has been proposed.

Fig. 4 shows the element construction in which the process sequence is used for the side wall construction.

This FET is also of P channel type and consists of the following process.

At first, it is the same as in the case of Fig. 1 that the gate oxide film 52 and polysilicone gate 53 are formed on the surface of the N type semiconductor substrate 51. Then, the silicone nitride film as thin as 150 - 300 Å is formed to cover the aforementioned polysilicon gate 53. Then, on the side wall of the polysilicone gate 53 covered with the silicone nitride film 60, a CVD oxide film 54, for example, is selectively formed. In this event, the tail end of the aforementioned silicone nitride film 60 is positioned at the end of the CVD oxide film 54. The process thereafter is the same as in the case of Fig. 1, and the $P^+$ type diffusion regions 55, 55, which serve as the source and drain regions, the CVD oxide film 56 as layer insulation film, and contact holes 57, 57 are formed respectively, and electrodes 58, 58 for the source and the drain are formed; then, the PSG film 59 is formed as a final passivation film.

The FET formed in this manner is covered with the silicone nitride film 60, at least, the vicinity of the polysilicone gate 53. For this reason, moisture resistance is expected to be improved as compared to the case of Fig. 1. However, the whole surface is not covered with the silicone nitride film 60 and only the gate electrode vicinity is covered; which causes uneasiness.

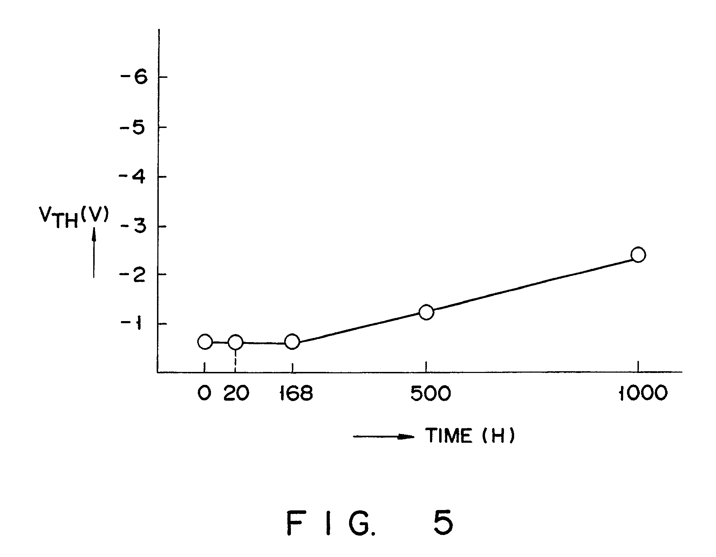

Fig. 5 shows the results when the similar stress test is carried out on the FET of the construction shown in Fig. 4. The test conditions in this case are same as those in Fig. 3. As clear from these characteristics, in the FET of the construction shown in Fig. 4, variations of threshold voltage are restricted sufficiently at the beginning of the test, but after about 500 hours, variations in characteristics which are less serious than the FET of Fig. 1 are observed, indicating that the FET of the construction of Fig. 4 does not serve as a good countermeasure for moisture resistance.

On the other hand, conventionally, an integrated circuit, in which MOSFET is allowed to form on the substrate and the laminated film comprising the PSG film and plasma silicone nitride film is used as a final passivation film is known. In this kind of integrated circuits, Si-H is formed simultaneously while the plasma silicone nitride film is formed, generating the nonconformance that the threshold voltage of the N channel MOSFET is varied due to free H (hydrogen) from the aforementioned Si-H.

In the semiconductor integrated circuit in which the silicone nitride film cannot be used as the final passivation film in this way, the use of silicone nitride film for the layer insulation film is proposed, but there is a reliability problem caused by the entry of moving ions and other impurities in any case with the conventional constructions.

In case of the semiconductor integrated circuit which has the MOSFET of the N channel formed on the substrate and uses the plasma silicone nitride film as the final passivation film, there is a reliability problem that hot electrons enter the defects of the gate oxide film.

Accordingly, the object of the present invention is to provide a MOS type semiconductor integrated circuit which is free from any effect of impurities such as moving ions or hot electrons.

According to this invention, the MOS type semiconductor integrated circuit is provided, throughout which the layer insulation film comprising at least one layer of silicone nitride film is formed except at the contact openings for electrode outputs.

This invention can be more fully understood from the following detailed description when taken in conjunction with the accompanying drawings, in which:

Fig. 1 is a cross-sectional view of the conventional MOSFET configuration;

Fig. 2 is a test circuit in which the stress test is conducted on the MOSFET;

Fig. 3 is a characteristic diagram showing the stress test results of the MOSFET shown in Fig. 1;

Fig. 4 is a cross-sectional view of the configuration of the conventional MOSFET different from the ones mentioned above;

Fig. 5 is a characteristic diagram showing stress test results of the MOSFET shown in Fig. 4;

Fig. 6 is a cross-sectional view showing the configuration of the MOSFET according to the first embodiment of the present invention;

Fig. 7 is a characteristic diagram showing the stress test results of the MOSFET according to the above-mentioned embodiment;

Fig. 8 is a cross-sectional view showing the MOSFET configuration according to the second embodiment of the present invention;

Figs. 9A and 9B are cross-sectional views showing the MOSFET configuration according to the third embodiment of the present invention; and

Fig. 10 is a cross-sectional view showing the MOSFET configuration according to the fourth embodiment of the present invention.

Referring now to the drawings, embodiments of the present invention will be described in detail hereinafter.

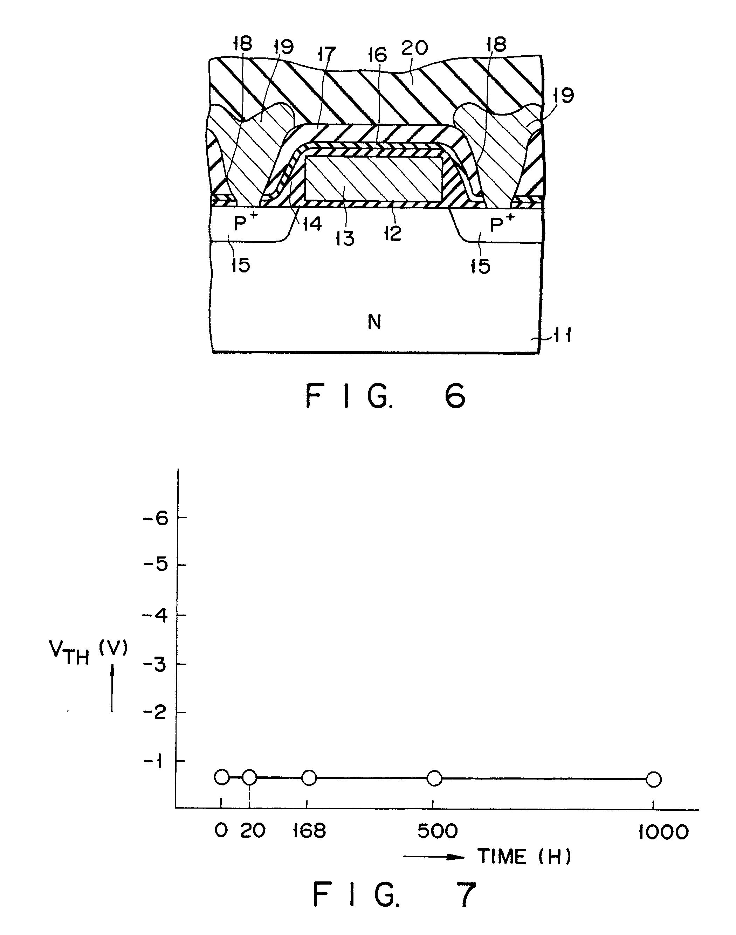

Fig. 6 shows the cross-sectional construction of the MOSFET of the P channel formed in the integrated circuit of the first embodiment of the present invention. The FET of this type of construction is formed in the following process.

That is, at first, the gate oxide film 12 is formed on the surface of the N type semiconductor substrate 11. Then, the polysilicone gate 13 is formed by the known PEP (photo etching process). Thereafter, the CVD oxide film 14, for example, is formed selectively only on the side wall of the polysilicone gate 13.

Then, on the outside of the above-mentioned CVD oxide film 14, the $P^+$ type diffusion regions 15, 15, which become the source and drain regions, are formed by, for example, the ion injection process. Then, after on the entire surface, for example, the silicon nitride film 16 as thin as 150 - 300 Å (15 - 30 nm) is formed, the phosphorus (P) or boron (B) containing CVD oxide film 17 is formed on the entire surface as the layer insulation film, and the contact holes 18, 18, which are connected to the respective surfaces of the above-mentioned $P^+$ type diffusion regions 15, 15, are opened. Thereafter, the metallic film for wiring, for example, Aℓ (aluminum) film is evaporated on the entire surface, then, the above-mentioned A$\ell$ film is patterned and the source and drain electrodes 19, 19 are formed. Then, the laminated film 20 consisting of, for example, PSG film and BPSG (boron, phosphorus, silicate, glass) film, is formed on the entire surface as the final passivation film to complete.

In the MOSFET of this type of construction, the silicone nitride film 16 which blocks the moisture content containing impurities such as moving ions covers the greater part of the substrate. This makes it difficult for impurities such as moving ions to enter the gate oxide film 12 as compared to the conventional.

Fig. 7 shows the results of the stress test similar to the one mentioned above, which is conducted on the MOSFET of the construction as shown in Fig. 6. The test conditions in this event include 85° C for temperature, 85% for humidity, and -6 V for applied voltage.

These test results indicate that the thin silicone nitride film 16 is formed to cover the nearly entire surface of the FET and resistance to moisture is improved.

Because thickness of the silicon nitride film 16 is as thin as 150 - 300 Å (15 - 30 nm), the ultra-violet ray sufficiently penetrates the film when it is irradiated. Consequently, this can be used in an integrated circuit provided with the ultra-violet ray erasable semiconductor element such as EPROM, which requires ultra-violet ray irradiation. Furthermore, it is confirmed that the ultra-violet ray sufficiently penetrates the film, if the thickness of the above-mentioned silicone nitride film 16 is less than 1000 Å (100 nm).

Now, in the above-mentioned embodiment, the silicone nitride film 16 and the CVD oxide film 17 formed on its top together constitute the layer insulation film, and the silicone nitride film 16 is located at the lowest layer of the layer insulation film comprising these multiple layers, which is one of the features of this embodiment. That is, to prevent the entry of impurities, the route of impurity entry from surface to silicone nitride film is made longer to lower the impurity concentration on the silicone nitride film. With this arrangement, an integrated circuit with high reliability which is free from the effect of impurities can be formed. For this reason, the silicon nitride film must be located at the lowest layer of the layer insulation film.

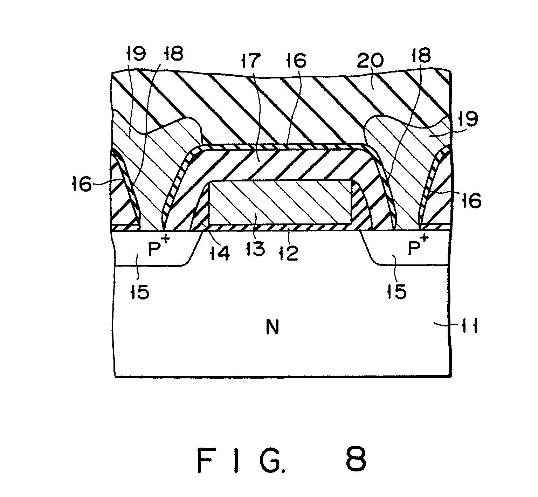

Fig. 8 shows the cross-sectional construction of the MOSFET related to the second embodiment of the present invention. The embodiment of Fig. 6 discussed above shows the case in which the layer insulation film is a two-layer insulation film comprising the silicone nitride film 16 and the CVD oxide film 17 and the silicone nitride film 16 is located at the lowest layer of the two-layer insulation film, but it is possible to locate the silicone nitride film 16 above the CVD oxide film 17 as in the case of MOSFET of this embodiment.

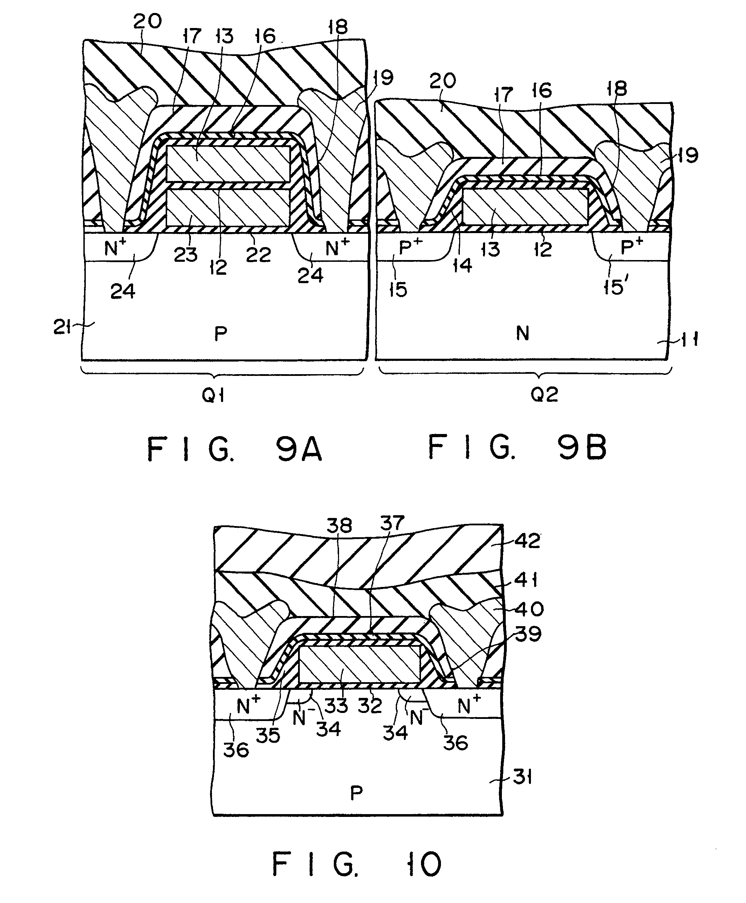

Figs. 9A and 9B show the construction of an element when the present invention is implemented in the semiconductor integrated circuit provided with the ultra-violet ray erasable semiconductor element such as EPROM (erasable programmable ROM). In general, in the EPROM, the memory cell in the memory cell array consists of the N channel MOSFET. Fig. 9A shows the N channel ultra-violet ray erasable MOSFET Q1 in the memory cell array, while Fig. 9B shows the ordinary P channel MOSFET Q2 in the peripheral circuit.

The above-mentioned P channel MOSFET Q2 is configured in the same manner as that shown in Fig. 6. On the other hand, the ultra-violet ray erasable MOSFET Q1 in the memory cell array is formed in the P-type well region 21 which is formed on the N-type semiconductor substrate 11. In this transistor Q1, the aforementioned polysilicone gate 13 becomes a control gate, the lower part of which the polysilicone gate 23 comprising the polysilicone layer of the first layer is formed on the gate oxide film 22 by the PEP process. This polysilicone gate 23 is used as a floating gate. In the P type well region 21, the $N^+$ type diffusion regions 24, 24, which will serve as the source and the drain regions of this FET, are formed.

Consequently, for example, in order to form the P channel MOSFET Q2 polysilicone gate 13 and the ultra-violet ray erasable MOSFET Q1 polysilicone gate 13 by using the polysilicone layer of the same layer, the polysilicone layer of the second layer is used.

Even if the silicone nitride film 16 is formed in this way on the entire surface other than the contact holes 18, 18, the film passes the ultra-violet ray sufficiently if the thickness of the silicon nitride film 16 is made as thin as 150 - 300 Å (15 - 30 nm), and the electrons injected during data writing is discharged from the floating gate.

Because also in this embodiment, the silicone nitride film 16 is formed to cover the nearly entire surface of the FET, good moisture resistance is achieved and variation in threshold voltage is reduced and the reliability is improved.

Also in this embodiment, since the silicone nitride film 16 which constitutes the layer insulation film is located at the lowest layer of the layer insulation film, a semiconductor integrated circuit with high reliability which is free from the effect of impurities can be formed for the same reasons mentioned above.

Fig. 10 is a cross-sectional view showing the element construction when the present invention is implemented in the integrated circuit containing the N-channel MOSFET of the LDD construction. The FET of this construction is manufactured in the following process.

That is, at first, the gate oxide film 32 is formed on the surface of the P-type semiconductor substrate 31. Then, the polysilicone gate 33 is formed by the known PEP process. Then, for example, the N- type diffusion regions 34, 34 which serve as low-concentration source and drain regions are formed by the ion injection process, for example, then, only selectively on the side wall of the polysilicone gate 33, for example, the CVD oxide film 35 is formed.

Next, on the outside of the above-mentioned CVD oxide film 35, for example, the $N^+$ type diffusion regions 36, 36 which serve as high-concentration source and drain regions are formed by the ion injection process, for example. Then, after on the entire surface, a silicone nitride film 37 as thin as 150 - 300 Å (15 - 30 nm), for example, is formed, the CVD oxide film 38 containing phosphorus (P) or boron (B) is formed on the entire surface as the layer insulation film. Further, after contact holes 39, 39 which are connected to the respective surfaces of the above-mentioned $N^+$ type diffusion regions 36, 36 are opened, the metallic film, such as Aℓ film, for wiring is evaporated on the entire surface and patterned to form the source and drain electrodes 40, 40. Then, on the entire surface, as the final passivation film, such as PSG film 41 and plasma machine silicone nitride film 42 are formed successively to complete.

In the semiconductor circuit of this embodiment, the plasma silicone nitride film is designed to form as the final passivation film. Consequently, as explained in the conventional example, Si-H is formed simultaneously in the plasma-silicone nitride film while the film is formed, and thereafter H is liberated. However, in this embodiment, because the silicone nitride film 37 is formed on the entire surface except the contact holes 39, 39, H liberated from Si-H is blocked in this silicone nitride film 37, preventing the H from entering the gate oxide film 32. As a result, even if the hot electron and holes are formed in the channel region by allowing the drain current to flow when this MOS transistor operates, the amount of hot electrons collecting at the interface of the gate oxide film 32 is extremely reduced, thereby preventing variations of threshold voltage.

Furthermore, because also in this embodiment, the silicone nitride film 37 composing the layer insulation film is located at the lower layer of the layer insulation film, a semiconductor integrated circuit with high reliability which is free from the effect of impurities can be obtained by the reasons described as above.

Needless to say, the present invention shall not be limited to the above-mentioned embodiments but various modifications are possible within the scope of the invention claimed. For example, in the above-mentioned embodiments, cases in which the source and drain electrodes are formed by the use of Aℓ are explained, but other metals, such as tungsten (W) and gold (Au), may be used. In addition, in the above embodiments, the case of forming the CVD oxide film on the side wall of the polysilicone gate, that is, forming the side wall, is discussed, but this is not always necessarily formed.

As described above, with this invention, a semiconductor integrated circuit which is free from the effect of impurities such as moving ions and hot electrons can be provided.

Reference signs in the claims are intended for better understanding and shall not limit the scope.

## Claims

1. A MOS type semiconductor integrated circuit wherein layer insulation films (16,17; 37,38) including of at least one layer of silicon nitride film (16; 37) are formed on the entire surface excluding the contact openings (18; 39) for electrode outputs.

2. The MOS type semiconductor integrated circuit according to claim 1, characterized in that one or more transistors which have gate electrodes (13, 14; 33,35) of side wall construction are provided.

3. The MOS type semiconductor integrated circuit according to claim 1, characterized in that an ultra-violet ray erasable MOSFET (Q1) is provided as a memory cell.

4. The MOS type semiconductor integrated circuit according to claim 1, characterized in that a plasma CVD insulation film (42) is provided as the final protective film.

5. A MOS type semiconductor integrated circuit comprising:
   a semiconductor region (11);
   source and drain regions (15; 34, 36) which are formed separated from one another on the surface region of said semiconductor region;
   the gate electrode (13, 33) formed on the surface region of said semiconductor region between said source and drain regions;
   a pair of side walls (14,35) formed on the side walls in contact with said source and drain regions of said gate electrodes;
   layer insulation films (16,17; 37,38) formed on the entire surface including said gate electrodes and including at least one layer of silicon nitride films (16; 37);

a pair of openings (18, 39) formed to expose part of respective source and drain regions against said layer insulation film; and

source and drain electrodes (19;40) formed in contact with the surfaces of said source and drain regions via the above-mentioned pair of openings.

6. The MOS type semiconductor integrated circuit according to claim 5, characterized in that said drain regions (34,36) include low-concentration first impurity diffusion region (34) and high-concentration second impurity diffusion region (36).

7. The MOS type semiconductor integrated circuit according to any one of claims 1 to 5, characterized in that said layer insulation film includes multiple layers of insulation films containing said silicon nitride film (16; 37) and said silicon nitride film is located at the lowest layer of these multiple layers of insulation film.

8. The MOS type semiconductor integrated circuit according to any one of claims 1 to 5, characterized in that said silicon nitride film (16; 37) is less than 100 nm thick.

58    56    59    57

57

58

P⁺                    P⁺

53    52

55    54                    55

N                    51

F I G.    1

-6V
⊙—D

-6V
G—⊙    ⊣—→

⊙—S
0V

F I G.    2

F I G. 3

F I G. 4

F I G. 5

F I G. 6

F I G. 7

F I G. 8

FIG. 9A    FIG. 9B

FIG. 10